(19) Europäisches Patentamt
European Patent Office
Office européen des brevets

(11) **EP 2 772 661 B1**

(12) **EUROPÄISCHE PATENTSCHRIFT**

(45) Veröffentlichungstag und Bekanntmachung des Hinweises auf die Patenterteilung:
**01.04.2020 Patentblatt 2020/14**

(51) Int Cl.:
***F16F 15/027*** *(2006.01)*  ***G03F 7/20*** *(2006.01)*

(21) Anmeldenummer: **13157277.8**

(22) Anmeldetag: **28.02.2013**

(54) **VERFAHREN ZUR DIMENSIONIERUNG EINES SCHWINGUNGSISOLATORS**

METHOD FOR DIMENSIONING AN OSCILLATION INSULATOR

PROCÉDÉ DE DIMENSIONNEMENT D'UN ISOLATEUR DE VIBRATIONS

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**03.09.2014 Patentblatt 2014/36**

(73) Patentinhaber: **Integrated Dynamics Engineering GmbH**
**65479 Raunheim (DE)**

(72) Erfinder: **Kappel, Roland**
**65195 Wiesbaden (DE)**

(74) Vertreter: **Blumbach · Zinngrebe Patentanwälte PartG mbB**
**Alexandrastraße 5**
**65187 Wiesbaden (DE)**

(56) Entgegenhaltungen:
**DE-C1- 19 809 545     US-A- 6 129 185**
**US-A1- 2003 155 882     US-A1- 2006 060 791**

**EP 2 772 661 B1**

**Beschreibung**

Gebiet der Erfindung

Die Erfindung betrifft ein Verfahren zur Dimensionierung eines Schwingungsisolators für stationäre Schwingungsisolationsysteme, wie sie insbesondere in der Halbleiterlithographie verwendet werden.

Hintergrund der Erfindung

Schwingungsisolatoren, insbesondere solche mit pneumatischen, in horizontaler und vertikaler Richtung wirksamen Isolatoren sind bekannt.

Ein Schwingungsisolationssystem besteht aus einem auf zumindest 3 Schwingungsisolatoren gelagerten Rahmen oder Tisch, auf welchem Lithographiegeräte angeordnet werden können.

Die Offenlegungsschrift EP 2 071 211 A2 (Integrated Dynamics Engineering GmbH) zeigt einen Schwingungsisolator, welcher dafür vorgesehen ist, in einer Vakuumkammer verwendet zu werden. Auch die US2003/0155882 beschreibt einen gattungsgemäßen Schwingungsisolator.

Bei einem derartigen Schwingungsisolator, welcher auf dem pneumatischen Prinzip basiert, ist ein Arbeitsraum des Isolators abgeschlossen, insbesondere mittels eines Faltenbalgs.

Ein derartiger Faltenbalg hat den Nachteil einer vergleichsweise hohen Steifigkeit, insbesondere in einer horizontalen Richtung des Schwingungsisolators. Es lässt sich daher ohne weitere technische Komponenten bei einem derartigen Isolator kein System bereitstellen, welches eine nur sehr geringe Steifigkeit aufweist, wie dies bei offenen Isolatoren der Fall ist, bei denen Oberteil und Unterteil eines Isolators ständig durch einen Luftspalt voneinander beabstandet sind.

Die Patentschrift EP 1 359 341 B1 (Integrated Dynamics Engineering GmbH) zeigt eine magnetische Federeinrichtung mit negativer Steifigkeit, bei welcher ein Modul aus Permanentmagneten dem Gesamtsystem des Schwingungsisolators eine negative Steifigkeit hinzufügt. Hiermit kann die Gesamtsteifigkeit des Isolators in einer vertikalen Richtung beeinflusst werden, insbesondere um diese zu minimieren.

In horizontaler Richtung wird die Steifigkeit vor allem durch die verwendeten Membranen, insbesondere den verwendeten Faltenbalg bestimmt.

Um auch die Steifigkeit in horizontaler Richtung einstellen zu können, ist es aus der Patentschrift EP 174 4 215 B1 bekannt, ein Luftlager mit zwei Drehgelenken und einer zusätzlichen Blattfeder zu versehen, welche ein Knickpendel bildet und eine negative Steifigkeit in horizontaler Richtung hinzufügt.

Die Patentschrift EP 1 803 963 B1 (Integrated Dynamics Engineering GmbH) zeigt ein Luftlager mit zwei Drehgelenken, wobei über Magnetmittel eine positive Steifigkeit hinzugefügt wird, um die Steifigkeit des Gesamtsystems einzustellen zu können.

Schwingungsisolatoren sollten möglichst kompakt ausgebildet sein. Dies gilt insbesondere für Schwingungsisolatoren, welche innerhalb einer Vakuumkammer verwendet werden sollen, da der Bauraum innerhalb der Vakuumkammer sehr teuer ist.

Problematisch ist, dass die Schwingungsisolatoren in aller Regel sehr tieffrequent abgestimmt werden sollten. Um bei unterschiedlichen Randbedingungen eine tieffrequente Abstimmung zu erreichen, wird in der Regel das Volumen des Schwingungsisolators relativ großzügig dimensioniert. Um dennoch innerhalb einer Vakuumkammer möglichst wenig Bauraum für die Isolatoren zu gebrauchen, ist es daher aus der Praxis bekannt, den Arbeitsraum des Schwingungsisolators mit einem Zusatzvolumen zu verbinden, welches außerhalb der Vakuumkammer angeordnet ist.

Aufgrund des innerhalb der Vakuumkammer gesparten Bauraumes werden so Kosten gespart, obgleich die dafür erforderlichen Vakuumdurchführungen aufwändig auszuführen sind und eine weitere Quelle von Störungen, insbesondere aufgrund von Leckagen, darstellen.

Aufgabe der Erfindung

Der Erfindung liegt demgegenüber die Aufgabe zugrunde, einen Schwingungsisolator, insbesondere einen Schwingungsisolator, welcher zur Verwendung in einer Vakuumkammer ausgebildet ist, derart zu dimensionieren, dass basierend auf einer vorgegebenen Eigenfrequenz und einer vorgegebenen zu tragenden Last das Volumen des Schwingungsisolators möglichst klein gewählt werden kann.

Zusammenfassung der Erfindung

Die Aufgabe der Erfindung wird bereits durch ein Verfahren zur Dimensionierung eines Schwingungsisolators für ein stationäres Schwingungsisolationssystem nach Anspruch 1 gelöst.

Bevorzugte Ausführungsformen und Weiterbildungen der Erfindung sind dem Gegenstand der abhängigen Ansprüche zu entnehmen.

Die Erfindung betrifft ein Verfahren zur Dimensionierung eines Schwingungsisolators für ein stationäres Schwingungsisolationssystem.

Ein derartiges stationäres Schwingungsisolationssystem umfasst eine Mehrzahl an Schwingungsisolatoren, über die die zu isolierende Last in Form eines Rahmens oder Tisches, auf dem Lithographiegeräte angeordnet werden können, schwingungsisoliert gelagert ist.

Der Arbeitsraum umfasst ein Fluidvolumen, über welches ein Kolben in einer horizontalen und einer vertikalen Richtung schwingungsisoliert abgestützt wird. Es handelt sich mithin um ein in horizontaler und vertikaler Richtung wirksames Lager, welches insbesondere als Luftlager ausgebildet ist.

Die Erfindung betrifft insbesondere Schwingungsisolatoren, welche zur Verwendung in einer Vakuumkammer geeignet sind. Hierzu zählen insbesondere Schwingungsisolatoren, bei denen der Arbeitsraum mittels eines Faltenbalges geschlossen ist.

Der Schwingungsisolator weist des Weiteren Mittel zum Hinzufügen einer negativen Steifigkeit auf. Dies können insbesondere Magnete zum Hinzufügen einer negativen Steifigkeit in vertikaler Richtung oder Gelenke zum Hinzufügen einer negativen Steifigkeit in horizontaler Richtung sein.

Gemäß der Erfindung wird bei Berechnung eines für eine gewünschte Eigenfrequenz $f_0$ des Schwingungsisolators benötigten Volumens des Arbeitsraumes die negative Steifigkeit berücksichtigt.

Insbesondere wird bei der Berechnung die negative Steifigkeit der Mittel zum Hinzufügen einer negativen Steifigkeit berücksichtigt.

Der Kern der Erfindung beruht darauf, dass der Erfinder herausgefunden hat, dass die Kombination einer möglichst kleinen Kolbenfläche mit einem möglichst hohen Anteil an negativer Steifigkeit zu einem minimalen Volumen des Isolators führt.

Unter dem Arbeitsraum wird der Raum verstanden, welcher mit dem Kolben in Verbindung steht. Ein hinzugefügtes Zusatzvolumen zählt mithin, auch wenn dieses über eine Fluiddurchführung mit dem Isolator verbunden ist, ebenfalls zum Arbeitsraum.

Durch die Erfindung kann aber in vielen Fällen auch bei der Verwendung des Schwingungsisolators für eine Vakuumkammer auf ein hinzugefügtes Zusatzvolumen verzichtet werden, da der Schwingungsisolator selbst einen hinreichend kleinen Bauraum einnimmt.

Die Dimensionierung wird vorzugsweise für zumindest drei, besonders bevorzugt für sechs Freiheitsgrade, vorgenommen.

Bei der Berechnung für zumindest einen Freiheitsgrad wird vorzugsweise zunächst eine Summe aus positiver und negativer Steifigkeit gebildet.

Die benötigte Steifigkeit $k_{needed}$ kann anhand der zu tragenden Last und der benötigten Eigenfrequenz $f_0$ bestimmt werden.

Bei einer bevorzugten Ausführungsform der Erfindung weisen die Mittel zum Hinzufügen einer negativen Steifigkeit eine Steifigkeit $\alpha$ wie in Anspruch 8 zwischen 0,6 und 1,0 auf.

Durch die Erfindung kann ein optimiertes Schwingungsisolationssystem mit einer Mehrzahl von Schwingungsisolatoren bereitgestellt werden, welche vorzugsweise genau anhand der Randbedingungen am jeweiligen Einsatzort dimensioniert sind.

So unterscheidet sich insbesondere das Volumen des Arbeitsraumes der Schwingungsisolatoren voneinander.

<u>Beschreibung der Zeichnungen</u>

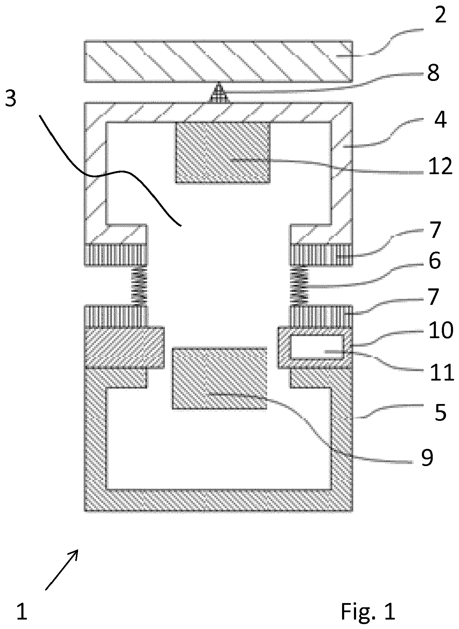

Die Erfindung soll im Folgenden Bezug nehmend auf ein schematisch dargestelltes Ausführungsbeispiel sowie ein Rechenbeispiel anhand der Fig. 1 bis Fig. 3 näher erläutert werden.

Fig. 1 zeigt eine schematische Ansicht eines Schwingungsisolators 1, welcher zu Verwendung in einer Vakuumkammer ausgebildet ist.

Der Schwingungsisolator 1 umfasst ein Gehäuse, auf welchem sich ein Kopfteil 2 befindet, welches mit der zu isolierenden Last (nicht dargestellt) verbunden wird.

Das Gehäuse des Schwingungsisolators 1 umfasst einen Arbeitsraum 3, der in diesem Ausführungsbeispiel verschlossen ist.

Hierzu umfasst das Gehäuse ein Oberteil 4 sowie ein Unterteil 5, welche über einen Faltenbalg 6 miteinander verbunden sind.

Aufgrund des im Arbeitsraum herrschenden Fluiddrucks wird das Oberteil 4 angehoben und in der Schwebe gehalten.

Die wirksame Kolbenfläche berechnet sich dabei aus dem Innendurchmesser des Oberteils 4 des Gehäuses abzüglich des durch einen Flansch 7 verdeckten Durchmessers.

Das Oberteil 4 sowie das Unterteil 5 sind mittels Flanschen 7 mit dem Faltenbalg 6 verbunden.

Weiter weist das Unterteil eine Kabeldurchführung 11 auf, mit der insbesondere im Oberteil 4 vorhandene Sensoren 12 angeschlossen sind.

Das Oberteil 4 ist über ein Gelenk 8 mit dem Kopfteil 2 verbunden. Faltenbalg 6 und Gelenk 8 bilden so ein Knickpendel, welches eine negative Steifigkeit in einer horizontalen Richtung hinzufügt.

Weiter umfasst der Schwingungsisolator 1 Mittel zum Hinzufügen einer negativen Steifigkeit 9 in vertikaler Richtung, welche insbesondere als magnetische Mittel, insbesondere solche wie in dem Dokument EP 1 359 341 B1 beschrieben, ausgestaltet sein können.

Aus dem Stand der Technik bekannte Isolatorgeometrien und - technologien bieten keinen weiteren Spielraum, die Baugröße der Isolatoren weiter zu verkleinern.

Durch die Berücksichtigung der negativen Steifigkeit bei der Dimensionierung ist mittels der Erfindung eine Möglichkeit gegeben, eine neue Optimierungsstrategie zu verwenden.

Das Volumen des Arbeitsraumes 3 einschließlich des Kolbendurchmessers kann gemäß der Erfindung wie folgt optimiert werden.

Im Allgemeinen wird eine Parameteroptimierung basierend auf sechs Freiheitsgraden durchgeführt, wobei die geometrischen Verhältnisse eines Systems zu Steifigkeitsmatrizen, die beteiligten Massen zu einem Trägheitstensor werden und die Optimierung im Vektorraum stattfindet.

Zur Vereinfachung der Darstellung wird im Folgenden die eindimensionale Ableitung vorgestellt.

Dem Fachmann gelingt die Verallgemeinerung auf sechs Freiheitsgrade unter Verwendung der Physik der Mechanik. Auf Grund der Übersichtlichkeit soll auf die vollumfängliche Darstellung in sechs Freiheitsgraden hier verzichtet werden.

Insbesondere der Faltenbalg 6 aus Metall führt eine zusätzliche, positive Steifigkeit in das System ein.

Da der Bauraum begrenzt ist, ist das Ziel des Verfahrens, das Isolatorvolumen zu minimieren. Gegeben sind in der Regel jedoch die zu tragende Masse $M$, sowie die Steifigkeit der beteiligten Komponenten (hier in vertikaler Richtung). Diese können als Summe der positiven und negativen Steifigkeiten beschrieben werden, wobei zu den bekannten Steifigkeiten auch sog. parasitäre Steifigkeiten zugelassen werden und die negative Steifigkeit mittels eines Faktors $\alpha$ in Abhängigkeit von der positiven Steifigkeit beschrieben wird:

$$k_{ges} = k_{pos} - k_{neg}$$

mit $k_{pos} = (k_{Ba\,lg} + k_{parasitär} + k_{Luftfeder})$ und $k_{neg} = (\alpha \cdot k_{pos})$

Die Steifigkeit des Metallfaltenbalges ergibt sich aus dessen wirksamer Kolbenfläche $A$ und der Anzahl der Knickfalten $N_{Falten}$. Es handelt sich dabei um Katalogdaten, die um empirische Messungen erweitert wurden und den derzeitigen Wissensstand zu Metallfaltenbälgen für zylindrische Isolatoren darstellen:

$$k_{Ba\,lg} = (A \cdot 4612.4\text{E}4 - 155.22\text{E}3)/\ N_{Falten}$$

Die Steifigkeit einer Luftfeder ist gegeben durch den Druck im Isolator $P_{Iso}$, dem ambienten Druck $P_{amb}$, der wirksamen Kolbenfläche $A$ des Isolators, dem Volumen des Isolators $V_{Iso}$ und der Gaskonstante $\kappa$.

$$k_{Luftfeder} = \kappa \cdot A^2 \frac{(P_{Iso} + P_{amb})}{V_{Iso}}$$

Für eine benötigte Eigenfrequenz $f_0$ des Isolators und einer gegebenen Masse $M$ lässt sich die benötigte Steifigkeit angeben zu

$$k_{needed} = (2\,\pi f_0)^2\, M$$

Damit ergibt sich eine Bestimmungsgleichung durch die Forderung der Gleichheit von benötigter Steifigkeit $k_{needed}$ und Gesamtsteifigkeit $k_{ges}$

$$k_{needed} \stackrel{!}{=} k_{ges}$$

$$\Leftrightarrow (2\pi f_0)^2 M = (A \cdot 4612.4\text{E}4 - 155.22\text{E}3)/\text{N}_{Falten} + k_{parasitär} + \kappa \cdot A^2 \frac{(P_{Iso} + P_{amb})}{V_{Iso}}$$

$$- (\alpha \cdot \left[ (A \cdot 4612.4\text{E}4 - 155.22\text{E}3)/\text{N}_{Falten} + k_{parasitär} + \kappa \cdot A^2 \frac{(P_{Iso} + P_{amb})}{V_{Iso}} \right])$$

Diese Gleichung kann man nach $V_{Iso}$ auflösen.

$$V_{Iso} = \frac{-625000 \kappa A^2 N_{Falten}(1-\alpha)(-P_{Iso} - P_{amb})}{(1-\alpha)(-0.288 \cdot 10^{14} A + 0.97 \cdot 10^{11} - 6.25 \cdot 10^5 k_{parasitär} N_{Falten}) + 2.4 \cdot 10^7 M N_{Falten} f_0^2}$$

Typischerweise verwendet man eine negative Steifigkeit im Bereich von $0.6 < \alpha < 1.0$ und einen Faltenbalg mit $8 < N_{Falten} < 25$.

Zusätzlich gelten für reale Systeme Beschränkungen bzgl. des maximalen Drucks im Isolator ($P_{Iso} < 0.7\text{MPa}$), womit sich über die Gleichgewichtsbeziehung zwischen Druck im Isolator, zu tragender Masse und Kolbenfläche

$$P = \frac{Mg}{A}$$ (mit der Erdbeschleunigung $g = 9.81 \text{m/s}^2$) eine minimal notwendige Fläche angeben lässt:

$$A_{min} = \frac{Mg}{P_{Iso,max}}$$

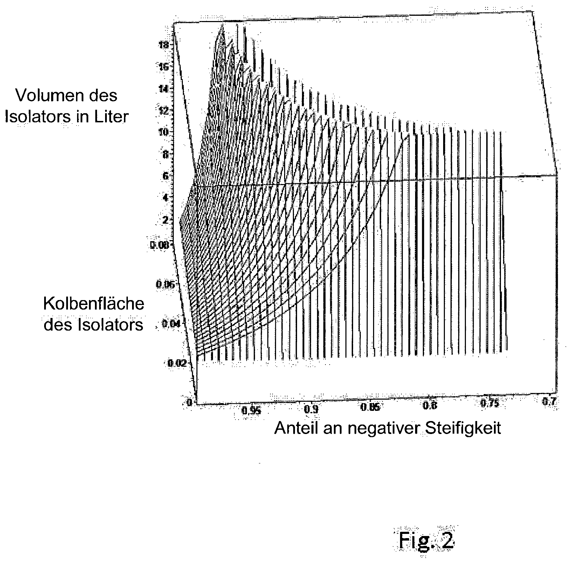

Für beispielhafte, der Realität nahe kommende Werte ergibt sich die Grafik gemäß Fig. 2 (M=1500kg, $f_0$=0.5Hz, ohne parasitäre Steifigkeiten).

Es ist aufgetragen nach rechts: Anteil an negativer Steifigkeit ($\alpha$), nach hinten: Kolbenfläche des Isolators A und nach hoben: Volumen des Isolators.

Man erkennt, dass eine minimale Kolbenfläche notwendig ist (hier knapp oberhalb von 0.02 m$^2$ und dort dann das benötigte Volumen bei fester Kolbenfläche mit abnehmender negativer Steifigkeit zunimmt.

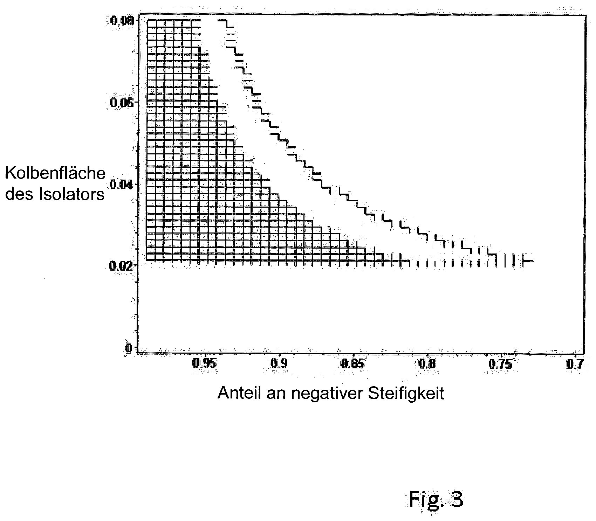

Man wird also, wie auch aus Fig. 3 ersichtlich, die Kolbenfläche klein halten, den Anteil an negativer Steifigkeit groß und erhielte damit einen Isolator mit minimalem Volumen.

Die Parameter für ein Beispielsystem sind durch Einsetzen in die vorstehenden Gleichungen erhältlich. Für M=1500kg, $f_0$=0.5Hz und ohne parasitäre Steifigkeiten gilt die angegebene Grafik. Danach würde man eine möglichst kleine Kolbenfläche wählen, sowie eine möglichst große negative Steifigkeit ($\alpha$), um ein möglichst geringes Volumen zu erhalten.

In der Praxis würde man mit einem kleineren $\alpha$ beginnen und damit ein etwas größeres Volumen wählen, um für Variationen in der negativen Steifigkeit genügend Raum zu haben. Dies kann nötig werden, wenn parasitäre Steifigkeiten hinzuaddiert werden, die einer Berechnung vorher nicht zugänglich waren.

Durch die Erfindung konnte das notwendige Volumen von Schwingungsisolatoren signifikant reduziert werden.

Bezugszeichenliste

| | |
|---|---|
| 1 | Schwingungsisolator |
| 2 | Kopfteil |
| 3 | Arbeitsraum |
| 4 | Oberteil |
| 5 | Unterteil |
| 6 | Faltenbalg |
| 7 | Flansch |
| 8 | Gelenk |

9     Mittel zum Hinzufügen einer negativen Steifigkeit
10    Bodenplatte
11    Kabeldurchführung
12    Sensormodul

**Patentansprüche**

1. Verfahren zur Dimensionierung eines Schwingungsisolators (1) für ein stationäres Schwingungsisolationssystem, welcher einen Arbeitsraum (3) mit einem Fluidvolumen umfasst, über welches ein Kolben in einer horizontalen und einer vertikalen Richtung schwingungsisoliert abgestützt wird, wobei der Schwingungsisolator Mittel zum Hinzufügen einer negativen Steifigkeit (9) in einer vertikalen Richtung aufweist, **dadurch gekennzeichnet, dass** bei Berechnung eines für eine gewünschte Eigenfrequenz $f_0$ des Schwingungsisolators benötigen Volumens des Arbeitsraumes (3) die negative Steifigkeit der Mittel zum Hinzufügen einer negativen Steifigkeit (9), eingeht, wobei bei der Berechnung für zumindest einen Freiheitsgrad zunächst eine Summe aus positiver und negativer Steifigkeit gebildet wird, und wobei eine benötigte Steifigkeit $k_{needed}$ anhand der zu tragenden Last und der benötigten Eigenfrequenz $f_0$ bestimmt wird.

2. Verfahren zur Dimensionierung eines Schwingungsisolators nach dem vorstehenden Anspruch, **dadurch gekennzeichnet, dass** die Dimensionierung für zumindest drei, vorzugsweise für sechs Freiheitsgrade vorgenommen wird.

3. Verfahren zur Dimensionierung eines Schwingungsisolators nach einem der vorstehenden Ansprüche, **dadurch gekennzeichnet, dass** bei der Dimensionierung das Volumen des Arbeitsraumes (3) minimiert wird.

4. Verfahren zur Dimensionierung eines Schwingungsisolators nach einem der vorstehenden Ansprüche, **dadurch gekennzeichnet, dass** ein Schwingungsisolator mit einem mittels eines Faltenbalges (6) geschlossener Arbeitsraum (3) dimensioniert wird.

5. Verfahren zur Dimensionierung eines Schwingungsisolators nach einem der vorstehenden Ansprüche, **dadurch gekennzeichnet, dass** ein Schwingungsisolator (1) dimensioniert wird, bei welchem die Mittel zum Hinzufügen einer negativen Steifigkeit (9) Magnete umfasst.

6. Verfahren zur Dimensionierung eines Schwingungsisolators nach einem der vorstehenden Ansprüche, **dadurch gekennzeichnet, dass** die Mittel zum Hinzufügen einer negativen Steifigkeit (9) eine Steifigkeit $\alpha$ zwischen 0,6 und 1,0 aufweisen.

**Claims**

1. A method for dimensioning a vibration isolator (1) for a stationary vibration isolation system, which vibration isolator comprises a working space (3) with a fluid volume, which supports a piston in a horizontal and a vertical direction in a vibration-isolated manner, wherein the vibration isolator includes means for adding a negative stiffness (9) in a vertical direction; **characterized in that** the negative stiffness of the means for adding a negative stiffness (9) is taken into account in calculating a volume of the working space (3) required for a desired natural frequency $f_0$ of the vibration isolator, wherein the calculation for at least one degree of freedom comprises to initially calculate a sum of positive and negative stiffnesses; and wherein a required stiffness $k_{needed}$ is determined on the basis of the load to be supported and the required natural frequency $f_0$.

2. The method for dimensioning a vibration isolator according to the preceding claim, **characterized in that** the dimensioning is performed for at least three, preferably for six degrees of freedom.

3. The method for dimensioning a vibration isolator according to any one of the preceding claims, **characterized in that** the volume of the working space (3) is minimized in the dimensioning.

4. The method for dimensioning a vibration isolator according to any one of the preceding claims, **characterized in that** a vibration isolator having a working space (3) that is closed by a bellows (6) is dimensioned.

5. The method for dimensioning a vibration isolator according to any one of the preceding claims, **characterized in that** a vibration isolator (1) is dimensioned, in which the means for adding a negative stiffness (9) comprise magnets.

6. The method for dimensioning a vibration isolator according to any one of the preceding claims, **characterized in that** the means for adding a negative stiffness (9) have a stiffness $\alpha$ between 0.6 and 1.0.

**Revendications**

1. Procédé pour le dimensionnement d'un isolateur de vibrations (1) pour un système d'isolation de vibrations stationnaire, qui comprend un espace de travail (3) avec un volume de fluide, par l'intermédiaire duquel un piston est soutenu de manière isolée en vibrations dans une direction horizontale et dans une direction verticale, l'isolateur de vibrations comprenant des moyens pour l'ajout d'une rigidité négative (9) dans une direction verticale, **caractérisé en ce que**, lors du calcul d'un volume de l'espace de travail (3) nécessaire pour une fréquence propre $f_0$ souhaitée de l'isolateur de vibrations, la rigidité négative des moyens d'ajout d'une rigidité négative (9) est prise en compte,
où, lors du calcul pour au moins un degré de liberté, une somme d'une rigidité positive et d'une rigidité négative est formée et
où une rigidité $k_{needed}$ nécessaire est déterminée à l'aide de la charge à porter et de la fréquence propre $f_0$ nécessaire.

2. Procédé de dimensionnement d'un isolateur de vibrations selon la revendication précédente, **caractérisé en ce que** le dimensionnement est effectué pour au moins trois, de préférence pour six degrés de liberté.

3. Procédé de dimensionnement d'un isolateur de vibrations selon l'une des revendications précédentes, **caractérisé en ce que**, lors du dimensionnement, le volume de l'espace de travail (3) est minimisé.

4. Procédé de dimensionnement d'un isolateur de vibrations selon l'une des revendications précédentes, **caractérisé en ce qu'**un isolateur de vibrations est dimensionné avec un espace de travail (3) fermé au moyen d'un soufflet (6).

5. Procédé de dimensionnement d'un isolateur de vibrations selon l'une des revendications précédentes, **caractérisé en ce qu'**un isolateur de vibrations (1) est dimensionné, dans lequel les moyens d'ajout d'une rigidité négative (9) comprennent des aimants.

6. Procédé de dimensionnement d'un isolateur de vibrations selon l'une des revendications précédentes, **caractérisé en ce que** les moyens d'ajout d'une rigidité négative (9) présentent une rigidité $\alpha$ entre 0,6 et 1,0.

Fig. 1

Fig. 2

Fig. 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2071211 A2
- US 20030155882 A
- EP 1359341 B1
- EP 1744215 B1
- EP 1803963 B1